# EUROPEAN PATENT SPECIFICATION

(11) **EP 3 791 133 B1**
(45) Date of publication and mention of the grant of the patent: **08.10.2025**
(21) Application number: 19733862.7
(22) Date of filing: 02.05.2019
(51) Int. Cl.: G01C 19/5677

(54) **PIEZOELECTRIC RING GYROSCOPE**
PIEZOELEKTRISCHER RINGKREISEL
GYROSCOPE À ANNEAU PIÉZOÉLECTRIQUE

(30) Priority: 08.05.2018 FI 20185420
(43) Date of publication of application: 17.03.2021
(73) Proprietor: Murata Manufacturing Co., Ltd., Nagaokakyo-shi, Kyoto 617-8555 (JP)
(72) Inventor: KUISMA, Heikki, 00420 Helsinki (FI)
(74) Representative: Boco IP Oy Ab
(86) International application number: PCT/IB2019/000324
(87) International publication number: WO 2019/215490

(56) References cited:
- FR-A1- 2 723 635
- US-A1- 2010 281 976
- US-A1- 2011 308 315

## Description

### FIELD OF THE DISCLOSURE

The present disclosure relates to sensor for measuring angular rotation rates, and more particularly to z-axis gyroscopes where the oscillation of a ring-shaped structure in a given plane is utilized to detect the magnitude of angular rotation about an axis perpendicular to that plane. The present disclosure further concerns transducers which may be used to drive the primary ring oscillation, to measure the magnitude of the primary ring oscillation, to detect the secondary ring oscillation induced by angular rotation, or to drive oscillation in the secondary mode that may cancel by electromechanical feed-back the induced oscillation, and/or dampen the secondary resonance peak, and/or cancel the directly coupled secondary mode oscillation that is in quadrature phase to the induced oscillation.

### BACKGROUND OF THE DISCLOSURE

Microelectromechanical gyroscopes use the Coriolis effect to measure angular velocity. In oscillating MEMS gyroscopes, an object is driven into oscillating movement by an actuating drive force. This oscillation will be called "primary oscillation" or "drive oscillation" in this disclosure, and the oscillation mode will be labelled called the "primary mode". It may also be labelled the "primary resonance mode", since the ring typically oscillates in resonance. In MEMS gyroscopes the drive oscillation can involve linear or rotational oscillation of a solid inertial mass, but it can also involve flexible deformation of a ring-shaped structure. This disclosure focuses exclusively on applications of the latter kind.

When a ring in drive oscillation undergoes an angular rotation rate Ω about the z-axis (perpendicular to the xy-plane defined by the ring), the ring is affected by the Coriolis force F_{c}. The magnitude and direction of the Coriolis force on a given segment of the ring is determined by the magnitude and direction of oscillating motion on that segment of the ring and by the magnitude of the angular rotation rate vector. The oscillation caused by the Coriolis force in the ring will be called "secondary oscillation" or "sense oscillation" in this disclosure, and the oscillation mode will be labelled called the "secondary mode" or the "secondary resonance mode".

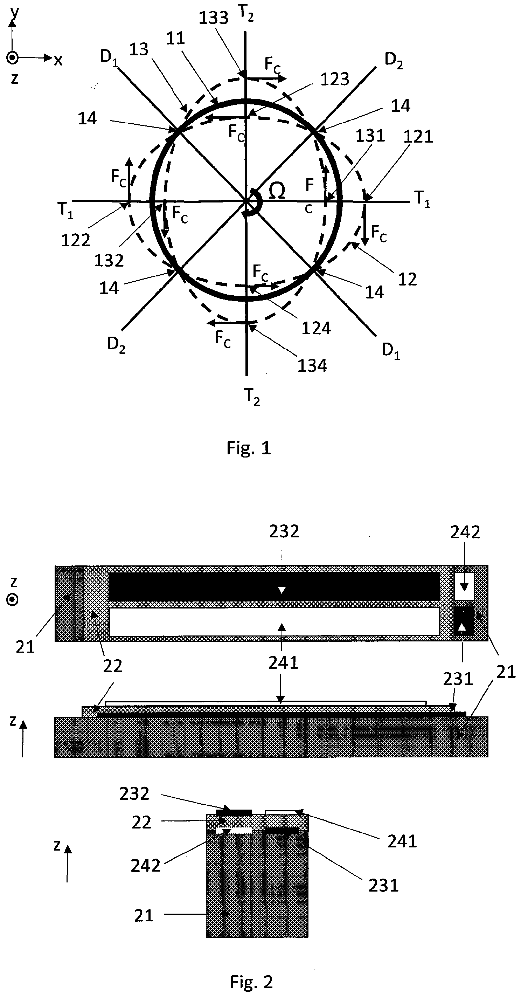

Figure 1 illustrates the primary and secondary modes in an oscillating ring gyroscope. The thick ring 11 illustrates the ring in its rest position, which it obtains when it is entirely at rest or when the amplitudes of all oscillation modes are zero. Two transversal symmetry axes T₁ and T₂ and two diagonal symmetry axes D₁ and D₂ are illustrated in the ring shown in Figure 1.

The primary mode involves ring oscillation along the two transversal symmetry axes. The two extremes of this oscillating movement have been illustrated with dotted lines in Figure 1. The first dotted line 12 shows the shape of the ring when it has expanded along the first transversal axis T₁ and contracted along the second transversal axis T₂, while the second dotted line 13 shows the shape of the ring when it has expanded along the second transversal axis T₂ and contracted along the first transversal axis T₁. In primary oscillation the ring continuously switches between these two shapes.

When the ring undergoes an angular rotation rate Ω about the central z-axis (illustrated in the middle of the ring), segments on the ring are influenced by the Coriolis force F_{c}. The forces F_{c} marked on the first dotted line 12 illustrate the local direction of the Coriolis force when the ring is expanding along the first transversal axis T₁. When segment 121 on the right-hand side moves in the positive x-direction, F_{c} points in the negative y-direction in this segment. When segment 122 on the left-hand side moves in the negative x-direction, F_{c} points in the positive y-direction in this segment. Simultaneously, segment 123 moves in the negative y-direction and F_{c} points in the negative x-direction in this segment. Segment 124 moves in the positive y-direction and F_{c} points in the positive x-direction in this segment, as illustrated in Figure 1. When the ring again contracts along the first transversal axis T₁, the direction of the Coriolis forces are reversed in each segment (this situation is not illustrated).

Similarly, the forces F_{c} marked on the second dotted line 13 illustrate the local direction of the Coriolis force when the ring is expanding along the second transversal axis T₂. When segment 131 moves in the negative x-direction, F_{c} points in the positive y-direction. When segment 132 moves in the positive x-direction, F_{c} points in the negative y-direction. Segment 133 moves in the positive y-direction and F_{c} points in the positive x-direction, while segment 124 moves in the negative y-direction and F_{c} points in the negative x-direction in this segment. The direction of the Coriolis forces are again reversed in each segment when the ring again contracts along the second transversal axis T₂ (this situation is not illustrated).

It can be seen from Figure 1, that in the first oscillation extreme (12) of the ring, the Coriolis force acting on segments 121 - 124 expands the ring along the first diagonal axis D₁. It simultaneously contracts the ring along the second diagonal axis D₂. In the second oscillation extreme (13), the Coriolis force acting on segments 131 - 134 expands the ring along the second diagonal axis D₂ and contracts it along the first diagonal axis D₁. Segments 121 - 124 are the same parts of the ring as segments 131 - 134, respectively, but represent different phases of the oscillation.

For simplicity, the Coriolis force has been drawn only on these segments of the ring in Figure 1. In reality, the Coriolis force will act at every point of the ring along its perimeter. Each local force component is proportional to the velocity of that point of the ring and to the angular rate, and is perpendicular to both. The integral of all the Coriolis force components causes an elliptic deformation of the ring along the first and second diagonal axes D₁ and D₂.

In other words, in the primary resonance mode the annular ring 11 deforms periodically to elliptic shapes 12 and 13 along the orthogonal transversal axes T₁ and T₂. If no angular rotation about the z-axis is present, there are four stationary nodal points 14 located at an angle of exactly 45 degrees from the transversal axes T₁ and T₂. These points 14 lie on the diagonal axes D₁ and D₂. The segments of the ring which lie at these nodal points 14 do not experience any linear movement in primary oscillation, only rotation around the node point.

In the secondary resonance mode, the elliptical deformations are turned by 45 degrees from the primary mode axes, as explained above. Mathematically (but not geometrically), the secondary mode is orthogonal to the primary mode, since all possible first order oscillations of the ring can be expressed as linear combinations of these two modes.

When the ring has been excited to the primary oscillation mode and undergoes an in-plane rotation around its center at a given rotation rate, the superposition of the two oscillations is an elliptic oscillation where the nodal points 14 are slightly shifted from the original locations. The angular rotation rate can be detected by measuring this shift.

Ring gyroscopes where the oscillations of the ring are driven by capacitive or electromagnetic means are known from the prior art. The detection of the secondary oscillation is typically performed by capacitive means. Documents US5932804 and US5226321 exemplify such gyroscopes.

Capacitive transducers have to be manufactured near the side surfaces of the ring by placing an electrode at a distance from the side surface, so that a voltage applied between the ring and the electrode is able to deform the ring (in the primary mode), or that the deformation of the ring (in the secondary mode) can be measured by the capacitance between the ring and the electrode. Electromagnetic excitation of the primary mode requires conductors formed on the top surface of the ring which impart a force to the ring when it is placed in an external magnetic field produced by a permanent magnet.

In these gyroscopes the detection capacitances are very small since it is very difficult to manufacture air gaps smaller than 1 µm, and the high amplitude of the primary oscillation puts limits on how far from the nodal points the secondary mode detection electrodes can be extended. On the other hand, the excitation capacitors needed for the primary mode must have a large gap to allow large amplitude oscillation, and thus the electrostatic force generated by these capacitors remains very small. If electromagnetic excitation is used, there is no space for multi-turn conductors on the ring, and a strong and large permanent magnet therefore has to be used. Such devices are typically not compatible with the standard packaging requirements of silicon devices.

Applying a voltage to a piezoelectric element to excite a vibration or obtaining a voltage signal generated due to deformation of a piezoelectric element is also known in the field of vibrating gyroscope, for instance from documents US2011/308315 A1, US2010/281976 A1, or FR2723635 A1.

### BRIEF DESCRIPTION OF THE DISCLOSURE

An object of the present disclosure is to provide an apparatus which alleviates the above disadvantages.

According to a first aspect of the invention, a ring gyroscope is provided as set forth in appended independent claim 1. According to a second aspect of the invention, a method for using a ring gyroscope is provided as set forth in appended independent claim 7. The preferred embodiments of the disclosure are disclosed in the dependent claims.

The disclosure is based on the idea of utilizing piezoelectric transducers for exciting the primary resonance mode in the ring gyroscope, for measuring the magnitude of the primary oscillation, for detecting the magnitude of the oscillation induced by the Coriolis force in the secondary resonance mode, and for driving an oscillation in the secondary mode that will by electromechanical feed-back cancel the induced oscillation and/ or dampen the secondary resonance peak, and/ or cancel the directly coupled secondary mode oscillation that is in quadrature phase to the induced oscillation. By placing piezoelectric transducers on suitable ring segments, stronger driving forces for the primary oscillation and lower signal-to-noise ratio for the detected induced oscillation can be obtained while at the same time providing the necessary additional functions of a practical gyroscope.

### BRIEF DESCRIPTION OF THE DRAWINGS

In the following the disclosure will be described in greater detail by means of preferred embodiments with reference to the accompanying drawings, in which
Figure 1 illustrates the primary and secondary modes in an oscillating ring gyroscope.
Figure 2 illustrates three cross-sections of a bending piezoelectric transducer placed on a gyroscope ring.
Figure 3 illustrates the variation of tangential stress along the inner and outer perimeters of a gyroscope ring.
Figure 4 illustrates a ring gyroscope.
Figure 5 illustrates a ring gyroscope.
Figure 6 illustrates a ring gyroscope.
Figure 7 illustrates a ring gyroscope.
Figure 8 illustrates a ring gyroscope.

### DETAILED DESCRIPTION OF THE DISCLOSURE

Figure 2 illustrates three cross-sections of a bending piezoelectric transducer placed on a gyroscope ring. The transducer can generate or measure bending motion in the xy-plane. A pair of first electrode layers 241 and 242 have been placed on silicon ring 21, one on the upper side of a layer of piezoelectric material 22 and one on the lower side (up and down refers in this case to the direction of the z-axis). These electrodes are paired with second electrode layers 231 and 232, respectively, as illustrated in the figure. Layers 241, 22 and 231 together form a first piezoelectric transducer on top of the ring 21, and layers 242, 22 and 232 together form a second piezoelectric transducer on top of the ring 21.

If drive voltages with opposite polarity are applied to these two transducers, the two transducers produce opposite strains in the xy-plane, which can deform silicon ring 21. If the transducers are used as sense transducers, in-plane bending will generate a voltage differential between the two transducers.

The drawing conventions of Figure 2 will be employed throughout this disclosure to illustrate piezoelectric transducers. In other words, two parallel rectangles of opposite colour will be used to indicate a piezoelectric transducer. For simplicity, these two parallel rectangles will primarily be referred to in the singular, as a single "split transducer", even though the structure is actually a construction which comprises two transducers. In other words, a split transducer must comprise two parallel transducers.

Black and white colours indicate transducer polarity. The ordering of the black and white rectangles in a split transducer indicate polarity so that the polarity of a transducer with a white rectangle on the outer side of the ring is opposite to the polarity of a transducer with a black rectangle on the black rectangle on the outside of the ring (as seen in the same figure).

The piezoelectric layer 22, which may be an aluminium nitride (AIN) layer, is typically not thicker than a few micrometers. The thickness of the silicon ring 21 may, for example, be between 4 - 100 µm, preferably between 10 - 50 µm.

When piezoelectric transducers described in this disclosure are used in the sense mode, the largest output voltage between the electrodes of the transducer may be achieved when the transducer capacitance equals the sum of the capacitance of the external connections and the input capacitance of the amplifier. The capacitance of the transducer is determined by its area and by the thickness of the piezoelectric layer.

Due to the narrowness of a gyroscope ring, certain design tradeoffs have to be made when piezoelectric transducers are fabricated on the top surface of the ring. A practical split electrode transducer requires at least 15 µm, preferably at least 20 µm of width. But if, for example, one would wish to fabricate a ring gyro with 30 kHz resonant frequency and 1 mm diameter, the ring width has to be less than 7 µm, which is too narrow for split transducers.

In order to implement piezoelectric transduction on basic gyroscope ring, the width of the ring must be increased. This increases the resonance frequency. A ring width of 15 µm increases the resonant frequency to 67 kHz. But even this may be too narrow, because the total maximum capacitance of a 15 µm wide split transducer with a 1 µm AIN layer is only 3,7 pF, which will be shared with many functions in addition to sensing the secondary oscillation: e.g. driving the primary oscillation, sensing the magnitude of the primary oscillation and driving a compensating signal in the secondary mode to cancel the secondary oscillation in a closed feed-back loop and/or damping the secondary resonance and/or cancelling the quadrature signal. For perfect match to the surrounding electronics, the total capacitance should preferably be 7-15 pF since it is not easy to use more than 50% of the maximum capacitance for sensing the secondary oscillation.

Increasing ring width to 30 µm makes the capacitance 7.6 pF, but the corresponding resonance frequency is then 140 kHz. At high frequency operation the gyroscope becomes more immune to external vibrations, which are predominantly at lower frequencies, but the quadrature signal due to direct mechanical coupling of the primary mode to the transducers which should measure only the secondary mode will also increase with frequency. The desired signal-to-noise ratio may therefore have to be weighed against the required quadrature compensation at a given resonance frequency. The ring width may, for example, be 15 - 30 µm, 15 - 25 µm or 15 - 20 µm.

An obvious way to increase the width of the ring and the capacitance without increasing the resonant frequency too much is to increase the diameter of the ring. If the diameter is chosen to be 1.6 mm and the width 18 µm, the resonant frequency will be 31 kHz and the capacitance 7.2 pF, numbers which are close to an ideal target. But this gyroscope will have 2.5 times as large area as a 1 mm diameter gyroscope and thus 2.5 times the manufacturing costs of the 1 mm diameter gyroscope.

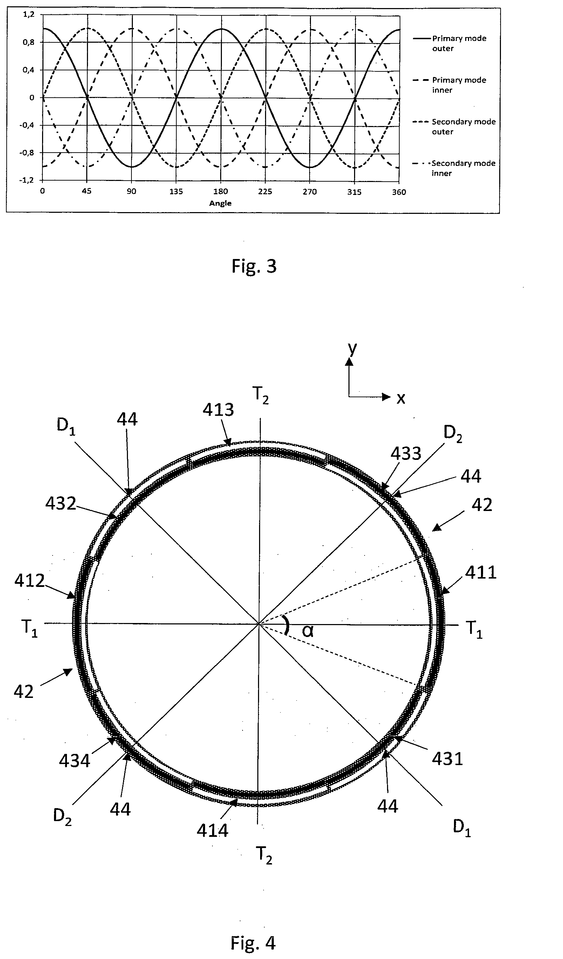

The primary and secondary oscillation modes produce mechanical stress on the inner and outer perimeter of the ring. The momentary stress varies as a sinusoidal function of length along the ring perimeter. The length variable is in this case represented by the clockwise angle with respect to the T₂-axis pointing in the positive y-direction in Figure 1. Figure 3 shows the variation of tangential stress along the inner and outer perimeters of the ring for both oscillation modes. At the illustrated moment, the stress varies as a cosine-function of the angle for the primary mode and as a sine-function for the secondary mode, and the stress on the inner perimeter is in each case equal but opposite to the stress on the outer perimeter. As a function of time the amplitudes of the stresses of Figure 3 will vary proportional to sin(ωt), where ω is the angular frequency of the oscillation. The angular distribution along the perimeter of the ring will remain same independent of time. This stress distribution can be generated and detected by piezoelectric split transducers positioned on the top surface of the ring and lengthwise along the perimeter of the ring. A split transducer positioned on the ring for driving the primary oscillation will produce opposite and constant stress on each perimeter of the ring.

This disclosure describes a ring gyroscope which comprises a substantially circular and flexible ring which defines a ring plane, and which is flexibly suspended from a substrate so that the ring can undergo shape oscillation in the ring plane. The ring comprises first and second transversal symmetry axes in the ring plane which are orthogonal to each other. The ring also comprises first and second diagonal symmetry axes in the ring plane which are orthogonal to each other. The angle between each transversal symmetry axis and the adjacent diagonal symmetry axis is 45°.

The gyroscope further comprises one or more primary piezoelectric split transducers placed on first sectors of the ring, and one or more secondary piezoelectric split transducers placed on one or more second sectors of the ring. Each first sector crosses a transversal symmetry axis of the ring and is symmetric with respect to that symmetry axis. Each second sector crosses a diagonal symmetry axis of the ring and is symmetric with respect to that diagonal symmetry axis of the ring.

In this disclosure, expressions such as "a piezoelectric split transducer placed on sector A of the ring" always mean that a piezoelectric split transducer is placed on top of the ring in sector A of the ring. Figure 2 illustrates how split transducers may be placed on top of the ring.

This disclosure also describes a method for using a ring gyroscope described above, wherein the method comprises the steps of: applying to at least one primary piezoelectric split transducer a drive voltage signal to generate the primary oscillation mode in the ring gyroscope, and reading from at least one secondary piezoelectric split transducer a sense voltage signal to measure the oscillation amplitude of secondary oscillation in the ring gyroscope. The same method can be employed with any ring gyroscope described in this disclosure.

Figure 4 illustrates a ring gyroscope which comprises a ring 42. The planar ring defines the ring-plane which corresponds to the xy-plane in Figure 4. The suspension arrangement is not illustrated. The first and second transversal symmetry axes T₁ and T₂, and the first and second diagonal symmetry axes D₁ and D₂ correspond to the symmetry axes discussed above with reference to Figure 1. At least one primary piezoelectric split transducer 411 has been placed on the ring 42. This split transducer 411 covers a first sector of the ring which corresponds to the angle α, as illustrated in Figure 4. The midpoint of this sector (or, equivalently, the midpoint of the transducer 411) defines the direction of first transversal symmetry axis T₁. An alternating drive voltage applied to split transducer 411 will alternately stretch and compress the ring 42 along transversal symmetry axis T₁. In other words, since a circle has infinitely many symmetry axes, the direction of the first symmetry axis can be freely selected by the placement of the first primary split transducer 411. Once the first axis T₁ has been defined, the other three symmetry axes T₂, D₁ and D₂ have also already been uniquely defined, and the placement of subsequent primary and secondary split transducers on the ring must conform to the following requirements:
1. A second primary piezoelectric split transducer 412 is placed opposite to 411, on the other side of the ring. The midpoint of this second primary split transducer 412 must lie as close as possible to the first transversal symmetry axis T₁. In other words, split transducer 412 defines another first sector of the ring which must cross the transversal symmetry axis T₁ of the ring and be symmetric with respect to that axis. In this context, symmetry means that the sector extends equally far on both sides of the axis T₁. Since the second split transducer 412 illustrated in Figure 4 has the same polarity symmetry with respect to the center of the ring as the first split transducer 411, the drive voltage signal applied to transducer 412 should have the same phase as the drive voltage signal applied to transducer 411. The drive oscillations induced by these two split transducers will then reinforce each other. If the polarity of the second split transducer 412 with respect to the center of the ring would be opposite to the polarity of transducer 411, the drive voltage signals should exhibit a phase difference of 180°.
2. Third and fourth primary piezoelectric split transducers 413 and 414 are placed on opposite sides of the ring. Their positions are shifted from the positions of first and second primary piezoelectric split transducers 411 and 412 by 90°. The midpoints of these third and fourth primary split transducers 413 and 414 must lie as close as possible to the second transversal symmetry axis T₂. In other words, split transducers 413 and 414 define additional first sectors of the ring which must cross the transversal symmetry axis T₂ of the ring and be symmetric with respect to that axis. Since the third and fourth split transducer 413 and 414 illustrated in Figure 4 have the opposite polarity symmetry with respect to the center of the ring as the first split transducer 411, the drive voltage signal applied to split transducers 413 and 414 should have the same phase as the drive voltage signal applied to transducer 411. The ring will then be driven to contract along axis T₂ when it expands along axis T₁, and vice versa. If either one or both of split transducers 413 and 414 would have the same polarity as 411, then that transducer can be driven with a drive voltage signal which has been shifted 180° in relation to the signal applied to transducer 411.
3. One to four secondary piezoelectric split transducers 431 - 434 may be placed on fours sides of the ring, each shifted from the adjacent secondary split transducers by an angle of 90°. The midpoints of these secondary split transducers 431 - 434 must lie as close as possible to the either the first diagonal symmetry axis D₁ or the second diagonal symmetry axis D₂. As explained above, these diagonal symmetry axes are shifted from the transversal symmetry axes by an angle of 45°. Each secondary split transducer 431 - 434 defines a second sector of the ring. Each second sector must cross a diagonal symmetry axis of the ring and be symmetric with respect to that axis. As before, symmetry in this context means that the sector extends equally far on both sides of the diagonal symmetry axis. The polarity of the secondary split transducers with respect to the center of the ring may be chosen freely. Figure 4 illustrates the simplest alternative where the polarity of secondary split transducers 431 and 432, which cross the first diagonal symmetry axis D₁, is opposite to the polarity of secondary split transducers 433 and 434, which cross the second diagonal symmetry axis D₂. Since expansion along D₁ is always accompanied by contraction along D₂ and vice versa, the sense voltages obtained from all secondary split transducers 431 - 434 can in this case be joined directly together.

In other words, at least one primary piezoelectric split transducer should be present on the ring to excite the primary resonance motion of the ring. This excitation is achieved by applying an alternating voltage to the primary piezoelectric split transducer, with a frequency which is equal or close to the resonance frequency of the ring. The primary piezoelectric split transducers should preferably be placed symmetrically in relation to a transversal symmetry axis of the ring.

Additionally, at least one secondary piezoelectric split transducer should be present on the ring to detect the oscillation coupled by the Coriolis force when the ring rotates about its central axis which is perpendicular to the ring plane. The secondary piezoelectric split transducers should preferably be placed symmetrically in relation to a diagonal symmetry axis of the ring.

Misalignment of any first or second sector (i.e. any primary or secondary transducer) will induce unwanted coupling of primary oscillation into the secondary oscillation mode. This is a because a misaligned primary transducer 411 - 414 will generate oscillation which puts the adjacent nodal point 44 in motion, even though the nodal points 44 should remain stationary when the ring oscillates only in the primary resonance mode. The oscillation of the nodal point 44 will be picked up by secondary split transducers 431 - 434 and create an erroneous sense signal. Conversely, a misaligned secondary transducer will be centered at a point which differs from the nodal point 44, which also leads it to pick up the primary resonance oscillation and to produce an erroneous sense signal. If, on the other hand, all primary and secondary split transducers are perfectly aligned, then secondary split transducers 431 - 434 will only pick up the true secondary resonance mode, which is the oscillation of nodal points 44 induced by the Coriolis force.

A single primary piezoelectric split transducer on a first sector of the ring and a single secondary split transducer on a second sector of the ring is sufficient for operating the ring gyroscope. However, to improve the signal-to-noise ratio and reduce the possibility of errors due to misalignment, the number of both primary and secondary split transducers is increased according to geometry illustrated as illustrated in Figure 4.

In other words, the gyroscope comprises a first pair of primary piezoelectric split transducers 411, 412 on two first sectors which cross the first transversal symmetry axis T₁ on opposite sides of the ring 42. The gyroscope also comprises a second pair of primary piezoelectric split transducers 413, 414 on two first sectors which cross the second transversal symmetry axis T₂ on opposite sides of the ring 42. The first pair of primary piezoelectric split transducers 411, 412 may have a polarity-symmetry with respect to the center of the ring 42 which is opposite to the polarity-symmetry of the second pair of piezoelectric split transducers 413, 414 with respect to the center of the ring 42.

Furthermore, the gyroscope comprises a first pair of secondary piezoelectric split transducers 431, 432 on two second sectors which cross the first diagonal symmetry axis D₁ on opposite sides of the ring 42. The gyroscope also comprises a second pair of secondary piezoelectric split transducers 433, 434 on two second sectors which cross the second diagonal symmetry axis D₂ on opposite sides of the ring 42. The first pair of secondary piezoelectric split transducers 431, 432 may have a polarity-symmetry with respect to the center of the ring 42 which is opposite to the polarity-symmetry of the second pair of secondary piezoelectric split transducers 433, 434 with respect to the center of the ring 42.

In the ring gyroscope illustrated in Figure 4, the width of each first sector and each second sector is 45°. In other words, the length of each primary split transducer 411 - 414 and the length of each secondary split transducer 431 - 433 is equal to 1/8 of the ring circumference. In Figure 4, where there are eight split transducers in total, the primary and secondary split transducers together cover the entire circumference of the ring. This maximizes the force obtained from the primary transducers and the sense signal strength obtained from the secondary transducers.

However, sometimes some of the area on the top surface of the ring may be needed for other purposes than force transduction, for example drive amplitude monitoring, coupling cancellation or electrical contacting.

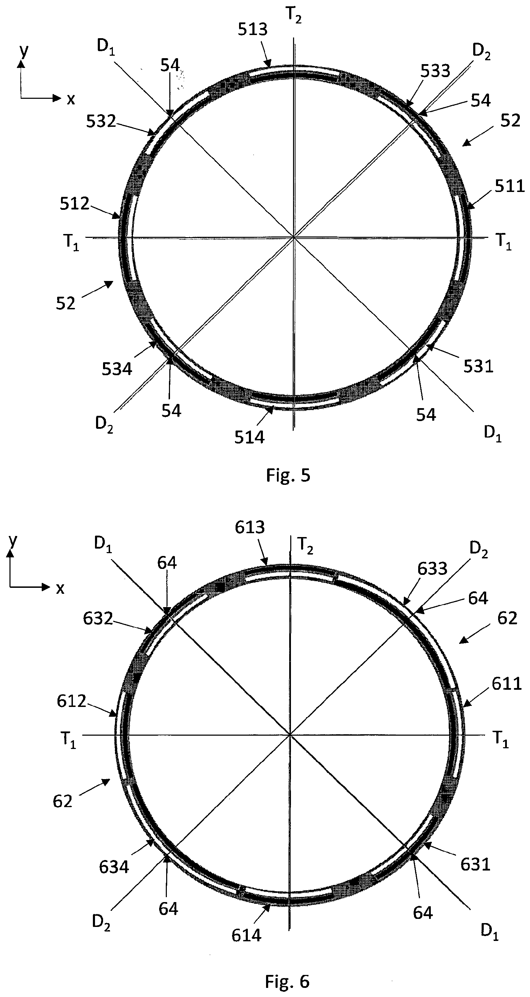

Figure 5 illustrates a ring gyroscope according to another example. Reference numbers 511 - 514, 531 - 534, 52 and 54 correspond to reference numbers 411 - 414, 431 - 434, 42 and 44, respectively in Figure 4. In Figure 5, the width of each first sector is less than 45°, and the width of each second sector is less than 45°. For illustrative purposes the length of each transducer is 1/16 of the ring circumference, so that the corresponding width of each first and second sector is 22.5°, but transducer lengths can be selected freely. The symmetry criterion remains the same as in Figure 4: each first and second sector should be symmetric with respect to the symmetry axis which it crosses. Deviations from this symmetry will cause unwanted coupling of primary mode oscillation into the secondary mode, as described above.

Figure 6 illustrates an alternative example where the width of all first sectors is less than 45°, the width of two second sectors is less than 45°, and the width of the two other second sectors is more than 45°. Reference numbers 611 - 614, 631 - 634, 62 and 64 correspond to reference numbers 511 - 514, 531 - 534, 52 and 54, respectively, in Figure 5. Alternatively, the width of each first sector may be less than 45°, and the width of each second sector may be more than 45°. These configurations, which open up some room on the ring surface by narrowing the first sectors, can be advantageous when driving force can be sacrificed but sense signal strength cannot.

The force required for driving the primary oscillation depends on the dimensions of the ring, the length of the primary transducers and the amplitude of the drive voltage signal applied to these primary transducers. As before, each first and second sector must still be symmetric with respect to the symmetry axis which it crosses.

Alternatively, the width of each first sector may be more than 45°, and the width of each second sector may be less than 45°. This configuration can be advantageous when the driving force must be maximized, but some of the sense signal strength can be sacrificed. This option is not separately illustrated, but it corresponds directly to Figure 6, except that each primary split transducer would cover more than 1/8 of the ring circumference, while no secondary split transducer would cover more than 1/8 of the circumference.

All primary split transducers do not necessarily have to be used for driving the primary oscillation. Some of them may, for example, be used for measuring the amplitude of the primary oscillation. This is needed for maintaining stable oscillation amplitude independent of the changes in the driving frequency or the Q-value of the resonator due to environmental variables or aging.

In other words, a method for using any ring gyroscope described in this disclosure may comprise the step of reading from at least one primary piezoelectric split transducer a third voltage signal to measure the oscillation amplitude of primary oscillation in the ring gyroscope.

Similarly, all secondary split transducers do not necessarily have to be used for measuring the secondary oscillation. Some of them may, for example, be used for active interventions into the secondary oscillation mode. For example, when the ring gyroscope is used in closed-loop servo mode, or when the secondary mode resonance is damped by closed loop feedback, or when an applied electromechanical force is used to cancel a quadrature signal, at least one secondary piezoelectric split transducer may be driven with an alternating voltage so that it actively cancels the coupling of the primary oscillation into the secondary oscillation. The lengths of the secondary transducers which are dedicated to active cancelling may differ from the lengths of the secondary transducers which sense the secondary oscillation.

In other words, a method for using any ring gyroscope described in this disclosure may comprise the step of applying to at least one secondary piezoelectric split transducer a fourth voltage signal to actively cancel the coupling of the primary oscillation into the secondary oscillation.

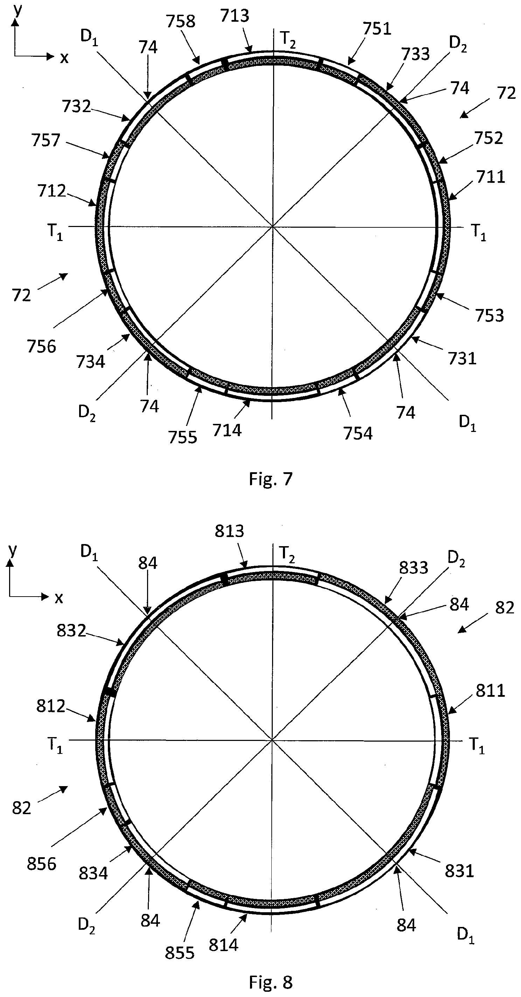

If the primary and secondary split transducers do not together cover the entire circumference of the ring, the vacant surface area (for example, the unused area on the ring in Figures 5 and 6) can be used for other purposes. Figure 7 illustrates an embodiment of the claimed invention where reference numbers 711 - 714, 731 - 734, 72 and 74 correspond to reference numbers 611 - 614, 631 - 634, 62 and 64, respectively, in Figure 6. In this embodiment, the width of at least one first or second sector is less than 45°. The gyroscope comprises one or more tertiary piezoelectric split transducers on third sectors of the ring, which do not overlap with the first sectors or the second sectors.

Eight tertiary piezoelectric split transducers 751 - 758 are illustrated in Figure 7. The number of tertiary piezoelectric split transducers could be smaller, and it may depend on the widths of the primary and secondary transducers. The number of tertiary piezoelectric split transducers may also be larger than eight. Several third sectors may fit between first and second sectors.

One or more of the tertiary piezoelectric transducers 751 - 758 may be used for detecting the amplitude of the primary oscillation. This amplitude may not remain constant during the lifetime of the device due to temperature stress and other aging effects. Drift in the drive amplitude will immediately introduce a proportional error in the sensed amplitude, but this error can be corrected if the primary oscillation is monitored.

In other words, a method for using a ring gyroscope which comprises one or more tertiary piezoelectric split transducers on third sectors of the ring which do not overlap with the first sectors or the second sectors may comprise the step of reading from at least one tertiary piezoelectric split transducer a fifth voltage signal to measure the oscillation amplitude of primary oscillation in the ring gyroscope.

One or more of the tertiary piezoelectric transducers 751 - 758 may also be used for cancelling coupled oscillation when the gyroscope is used in closed loop servo mode or when the secondary resonance mode is actively damped by closed-loop feedback, or when electromechanical force is used to cancel a quadrature signal, as described above. In other words, a method for using a ring gyroscope which comprises one or more tertiary piezoelectric split transducers on third sectors of the ring which do not overlap with the first sectors or the second sectors may comprise the step of applying to at least one tertiary piezoelectric split transducer a sixth voltage signal to actively cancel the coupling of the primary oscillation into the secondary oscillation.

Figure 8 illustrates an alternative embodiment of the claimed invention where reference numbers 811 - 814, 831 - 834, 855 - 856, 82 and 84 correspond to reference numbers 711 - 714, 731 - 734, 755 - 756, 72 and 74, respectively, in Figure 7. In this embodiment, three of the secondary transducers on the second sectors, 831-833, have a width larger than 45°, and the fourth one, 834, has a width less than 45°. All of these secondary transducers are used for detecting the secondary oscillation. All transducers on the primary sectors, 811-14, have a width less than 45°, and they are used for exciting the primary oscillation. There are only two tertiary transducers on third sectors, 855 and 856. One of these tertiary transducers is used for detecting the amplitude of the primary oscillation, as described above. The other is used for cancelling coupled oscillation when the gyroscope is used in closed loop servo mode or when the secondary resonance mode is actively damped by closed-loop feedback, or when electromechanical force is used to cancel a quadrature signal, as described above.

As indicated visually in Figure 8, the whole perimeter of the ring may be fully covered by transducers for the described functions. The gyroscope may be optimized by selecting optimum transducer lengths for each function, so that sufficiently high signal-to-noise ratios are obtained for the primary and secondary signals, while keeping the voltages for driving the primary oscillation and for cancelling coupled oscillation suitably low.

## Claims

1. A ring gyroscope which comprises:
- a substantially circular and flexible ring (72, 82) which defines a ring plane, and which is flexibly suspended from a substrate so that the ring can undergo shape oscillation in the ring plane, wherein the ring comprises first and second transversal symmetry axes (T₁, T₂) in the ring plane which are orthogonal to each other, and the ring also comprises first and second diagonal symmetry axes (D₁, D₂) in the ring plane which are orthogonal to each other, and the angle between each transversal symmetry axis and the adjacent diagonal symmetry axis is 45°,
wherein the gyroscope further comprises one or more primary piezoelectric split transducers (711-714, 811-814), and each of the one or more primary piezoelectric split transducers covers a corresponding first sector of the ring, wherein the one or more primary piezoelectric split transducers generate the primary oscillation mode in the ring gyroscope, and one or more secondary piezoelectric split transducers (731-734, 831-834), and each of the one or more secondary piezoelectric split transducers covers a corresponding second sector of the ring, wherein the one or more secondary piezoelectric split transducers measure the oscillation amplitude of secondary oscillation in the ring gyroscope,
and each first sector crosses a transversal symmetry axis of the ring and is symmetric with respect to that symmetry axis, and each second sector crosses a diagonal symmetry axis of the ring and is symmetric with respect to that symmetry axis, and the gyroscope further comprises one or more tertiary piezoelectric split transducers (751-758, 855-856),
and each of the one or more tertiary piezoelectric split transducers covers a corresponding third sector of the ring, and no third sector overlaps with a first sector or second sector,
wherein the one or more primary piezoelectric split transducers comprise a first pair of primary piezoelectric split transducers on two first sectors which cross the first transversal symmetry axis on opposite sides of the ring and a second pair of primary piezoelectric split transducers on two first sectors which cross the second transversal symmetry axis on opposite sides of the ring,
and the one or more secondary piezoelectric split transducers comprise a first pair of secondary piezoelectric split transducers on two second sectors which cross the first diagonal symmetry axis on opposite sides of the ring and a second pair of secondary piezoelectric split transducers on two second sectors which cross the second diagonal symmetry axis on opposite sides of the ring.

2. A ring gyroscope according to claim 1, **characterized in that** the first pair of primary piezoelectric split transducers has a polarity-symmetry with respect to the center of the ring which is opposite to the polarity-symmetry of the second pair of primary piezoelectric split transducers with respect to the center of the ring.

3. A ring gyroscope according to any of claims 1-2, **characterized in that** the first pair of secondary piezoelectric split transducers has a polarity-symmetry with respect to the center of the ring which is opposite to the polarity-symmetry of the second pair of secondary piezoelectric split transducers with respect to the center of the ring.

4. A ring gyroscope according to any of claims 1-3, **characterized in that** the width of each first sector is less than 45°, and the width of each second sector is more than 45°.

5. A ring gyroscope according to any of claims 1-3, **characterized in that** the width of each first sector is more than 45°, and the width of each second sector is less than 45°.

6. A ring gyroscope according to any of claims 1-3, **characterized in that** the width of each first sector is less than 45°, and the width of each second sector is less than 45°.

7. A method for using a ring gyroscope which comprises:
- a substantially circular and flexible ring which defines a ring plane, and which is flexibly suspended from a substrate so that the ring can undergo shape oscillation in the ring plane, wherein the ring comprises first and second transversal symmetry axes in the ring plane which are orthogonal to each other, and the ring also comprises first and second diagonal symmetry axes in the ring plane which are orthogonal to each other, and the angle between each transversal symmetry axis and the adjacent diagonal symmetry axis is 45°,
- one or more primary piezoelectric split transducers, and each of the one or more primary piezoelectric split transducers covers a corresponding first sector of the ring, wherein the one or more primary piezoelectric split transducers generate the primary oscillation mode in the ring gyroscope, and one or more secondary piezoelectric split transducers and each of the one or more secondary piezoelectric split transducers covers a corresponding second sector of the ring, wherein the one or more secondary piezoelectric split transducers measure the oscillation amplitude of secondary oscillation in the ring gyroscope, and each first sector crosses a transversal symmetry axis of the ring and is symmetric with respect to that symmetry axis, and each second sector crosses a diagonal symmetry axis of the ring and is symmetric with respect to that diagonal symmetry axis of the ring,
wherein the one or more primary piezoelectric split transducers comprise a first pair of primary piezoelectric split transducers on two first sectors which cross the first transversal symmetry axis on opposite sides of the ring and a second pair of primary piezoelectric split transducers on two first sectors which cross the second transversal symmetry axis on opposite sides of the ring,
and the one or more secondary piezoelectric split transducers comprise a first pair of secondary piezoelectric split transducers on two second sectors which cross the first diagonal symmetry axis on opposite sides of the ring and a second pair of secondary piezoelectric split transducers on two second sectors which cross the second diagonal symmetry axis on opposite sides of the ring, and
the ring gyroscope also comprises one or more tertiary piezoelectric split transducers, and each of the one or more tertiary piezoelectric split transducers covers a corresponding third sector of the ring, and no third sector overlaps with a first sector or a second sector, and that the method comprises the steps of:
- applying to at least one primary piezoelectric split transducer a drive voltage signal to generate the primary oscillation mode in the ring gyroscope,
- reading from at least one secondary piezoelectric split transducer a sense voltage signal to measure the oscillation amplitude of secondary oscillation in the ring gyroscope.

8. A method according to claim 7, **characterized in that** the method also comprises the step of reading from at least one primary piezoelectric split transducer a third voltage signal to measure the oscillation amplitude of primary oscillation in the ring gyroscope.

9. A method according to any of claims 7-8, **characterized in that** the method also comprises the step of applying to at least one secondary piezoelectric split transducer a fourth voltage signal to actively cancel the coupling of the primary oscillation into the secondary oscillation.

10. A method according to any of claims 7-9, **characterized in that** the method also comprises the step of reading from at least one tertiary piezoelectric split transducer a fifth voltage signal to measure the oscillation amplitude of primary oscillation in the ring gyroscope.

11. A method according to any of claims 7-10, **characterized in that** the method also comprises the step of applying to at least one tertiary piezoelectric split transducer a sixth voltage signal to actively cancel the coupling of the primary oscillation into the secondary oscillation.

## Patentansprüche

1. Ringgyroskop, umfassend:
- einen im Wesentlichen kreisrunden und flexiblen Ring (72, 82), der eine Ringebene definiert und der an einem Substrat flexibel aufgehängt ist, so dass der Ring eine Formschwingung in der Ringebene erfahren kann, wobei der Ring in der Ringebene eine erste und eine zweite Quersymmetrieachse (T₁, T₂) umfasst, die orthogonal zueinander sind, und der Ring in der Ringebene auch eine erste und eine zweite Diagonalsymmetrieachse (D₁, D₂) umfasst, die orthogonal zueinander sind, und der Winkel zwischen jeder Quersymmetrieachse und der angrenzenden Diagonalsymmetrieachse 45° beträgt,
wobei das Gyroskop ferner einen oder mehrere primäre piezoelektrische Splitwandler (711-714, 811-814) umfasst und jeder der einen oder mehreren primären piezoelektrischen Splitwandler einen entsprechenden ersten Sektor des Rings abdeckt, wobei der eine oder die mehreren primären piezoelektrischen Splitwandler die primäre Schwingmode im Ringgyroskop erzeugen, und einen oder mehrere sekundäre piezoelektrische Splitwandler (731-734, 831-834) umfasst und jeder der einen oder mehreren sekundären piezoelektrischen Splitwandler einen entsprechenden zweiten Sektor des Rings abdeckt, wobei der eine oder die mehreren sekundären piezoelektrischen Splitwandler die Schwingamplitude der sekundären Schwingung im Ringgyroskop messen,
und jeder erste Sektor eine Quersymmetrieachse des Rings schneidet und symmetrisch zu dieser Symmetrieachse ist, und jeder zweite Sektor eine Diagonalsymmetrieachse des Rings schneidet und symmetrisch zu dieser Symmetrieachse ist, und das Gyroskop ferner einen oder mehrere tertiäre piezoelektrische Splitwandler (751-758, 855-856) umfasst und jeder der einen oder mehreren tertiären piezoelektrischen Splitwandler einen entsprechenden dritten Sektor des Rings abdeckt, und kein dritter Sektor einen ersten Sektor oder zweiten Sektor überlappt,
wobei die einen oder mehreren primären piezoelektrischen Splitwandler ein erstes Paar von primären piezoelektrischen Splitwandlern an zwei ersten Sektoren, die die erste Quersymmetrieachse auf gegenüberliegenden Seiten des Rings schneiden, und ein zweites Paar von primären piezoelektrischen Splitwandlern an zwei ersten Sektoren, die die zweite Quersymmetrieachse auf gegenüberliegenden Seiten des Rings schneiden, umfassen,
und die einen oder mehreren sekundären piezoelektrischen Splitwandler ein erstes Paar von sekundären piezoelektrischen Splitwandlern an zwei zweiten Sektoren, die die erste Diagonalsymmetrieachse auf gegenüberliegenden Seiten des Rings schneiden, und ein zweites Paar von sekundären piezoelektrischen Splitwandlern an zwei zweiten Sektoren, die die zweite Diagonalsymmetrieachse auf gegenüberliegenden Seiten des Rings schneiden, umfassen.

2. Ringgyroskop nach Anspruch 1, **gekennzeichnet dadurch, dass** das erste Paar von primären piezoelektrischen Splitwandlern eine Polaritätssymmetrie zur Mitte des Rings aufweist, die entgegengesetzt zur Polaritätssymmetrie des zweiten Paars von primären piezoelektrischen Splitwandlern zur Mitte des Rings ist.

3. Ringgyroskop nach einem der Ansprüche 1 bis 2, **gekennzeichnet dadurch, dass** das erste Paar von sekundären piezoelektrischen Splitwandlern eine Polaritätssymmetrie zur Mitte des Rings aufweist, die entgegengesetzt zur Polaritätssymmetrie des zweiten Paars von sekundären piezoelektrischen Splitwandlern zur Mitte des Rings ist.

4. Ringgyroskop nach einem der Ansprüche 1 bis 3, **gekennzeichnet dadurch, dass** die Breite jedes ersten Sektors kleiner als 45° ist und die Breite jedes zweiten Sektors größer als 45° ist.

5. Ringgyroskop nach einem der Ansprüche 1 bis 3, **gekennzeichnet dadurch, dass** die Breite jedes ersten Sektors größer als 45° ist und die Breite jedes zweiten Sektors kleiner als 45° ist.

6. Ringgyroskop nach einem der Ansprüche 1 bis 3, **gekennzeichnet dadurch, dass** die Breite jedes ersten Sektors kleiner als 45° ist und die Breite jedes zweiten Sektors kleiner als 45° ist.

7. Verfahren zur Verwendung eines Ringgyroskops, das Folgendes umfasst:
- einen im Wesentlichen kreisrunden und flexiblen Ring, der eine Ringebene definiert und der an einem Substrat flexibel aufgehängt ist, so dass der Ring eine Formschwingung in der Ringebene erfahren kann, wobei der Ring in der Ringebene eine erste und eine zweite Quersymmetrieachse umfasst, die orthogonal zueinander sind, und der Ring in der Ringebene auch eine erste und eine zweite Diagonalsymmetrieachse umfasst, die orthogonal zueinander sind, und der Winkel zwischen jeder Quersymmetrieachse und der angrenzenden Diagonalsymmetrieachse 45° beträgt,
- einen oder mehrere primäre piezoelektrische Splitwandler, wobei jeder der einen oder mehreren primären piezoelektrischen Splitwandler einen entsprechenden ersten Sektor des Rings abdeckt, wobei die einen oder mehreren primären piezoelektrischen Splitwandler die primäre Schwingmode im Ringgyroskop erzeugen, und einen oder mehrere sekundäre piezoelektrische Splitwandler, wobei jeder der einen oder mehreren sekundären piezoelektrischen Splitwandler einen entsprechenden zweiten Sektor des Rings abdeckt, wobei die einen oder mehreren sekundären piezoelektrischen Splitwandler die Schwingamplitude der sekundären Schwingung im Ringgyroskop messen, und jeder erste Sektor eine Quersymmetrieachse des Rings schneidet und symmetrisch zu dieser Symmetrieachse ist, und jeder zweite Sektor eine Diagonalsymmetrieachse des Rings schneidet und symmetrisch zu dieser Diagonalsymmetrieachse des Rings ist,
wobei die einen oder mehreren primären piezoelektrischen Splitwandler ein erstes Paar von primären piezoelektrischen Splitwandlern an zwei ersten Sektoren, die die erste Quersymmetrieachse auf gegenüberliegenden Seiten des Rings schneiden, und ein zweites Paar von primären piezoelektrischen Splitwandlern an zwei ersten Sektoren, die die zweite Quersymmetrieachse auf gegenüberliegenden Seiten des Rings schneiden, umfassen,
und die einen oder mehreren sekundären piezoelektrischen Splitwandler ein erstes Paar von sekundären piezoelektrischen Splitwandlern an zwei zweiten Sektoren, die die erste Diagonalsymmetrieachse auf gegenüberliegenden Seiten des Rings schneiden, und ein zweites Paar von sekundären piezoelektrischen Splitwandlern an zwei zweiten Sektoren, die die zweite Diagonalsymmetrieachse auf gegenüberliegenden Seiten des Rings schneiden, umfassen, und
das Ringgyroskop auch einen oder mehrere tertiäre piezoelektrische Splitwandler umfasst, und jeder der einen oder mehreren tertiären piezoelektrischen Splitwandler einen entsprechenden dritten Sektor des Rings abdeckt, und kein dritter Sektor einen ersten Sektor oder einen zweiten Sektor überlappt, und wobei das Verfahren die Schritte umfasst:
- Anlegen eines Antriebsspannungssignals an mindestens einen primären piezoelektrischen Splitwandler, um die primäre Schwingmode im Ringgyroskop zu erzeugen,
- Auslesen eines Erfassungsspannungssignals aus mindestens einem sekundären piezoelektrischen Splitwandler, um die Schwingamplitude der sekundären Schwingung im Ringgyroskop zu messen.

8. Verfahren nach Anspruch 7, **gekennzeichnet dadurch, dass** das Verfahren auch den Schritt umfasst: Auslesen eines dritten Spannungssignals aus mindestens einem primären piezoelektrischen Splitwandler, um die Schwingamplitude der primären Schwingung im Ringgyroskop zu messen.

9. Verfahren nach einem der Ansprüche 7 bis 8, **gekennzeichnet dadurch, dass** das Verfahren auch den Schritt umfasst: Anlegen eines vierten Spannungssignals an mindestens einen sekundären piezoelektrischen Splitwandler, um die Einkopplung der primären Schwingung in die sekundäre Schwingung aktiv zu unterdrücken.

10. Verfahren nach einem der Ansprüche 7 bis 9, **gekennzeichnet dadurch, dass** das Verfahren auch den Schritt umfasst: Auslesen eines fünften Spannungssignals aus mindestens einem tertiären piezoelektrischen Splitwandler, um die Schwingamplitude der primären Schwingung im Ringgyroskop zu messen.

11. Verfahren nach einem der Ansprüche 7 bis 10, **gekennzeichnet dadurch, dass** das Verfahren auch den Schritt umfasst: Anlegen eines sechsten Spannungssignals an mindestens einen tertiären piezoelektrischen Splitwandler, um die Einkopplung der primären Schwingung in die sekundäre Schwingung aktiv zu unterdrücken.

## Revendications

1. Gyroscope à anneau qui comprend :
- un anneau essentiellement circulaire et flexible (72, 82) qui définit un plan annulaire et qui est suspendu de manière flexible à un substrat de telle façon que l'anneau puisse subir une oscillation de forme dans le plan annulaire, ledit anneau comprenant des premier et deuxième axes de symétrie transversale (T₁, T₂) dans le plan annulaire qui sont orthogonaux entre eux, et ledit anneau comprenant également des premier et deuxième axes de symétrie diagonale (D₁, D₂) dans le plan annulaire qui sont orthogonaux entre eux, et l'angle entre chaque axe de symétrie transversale et l'axe de symétrie diagonale adjacent étant de 45°,
dans lequel le gyroscope comprend en outre un ou plusieurs transducteurs divisés piézoélectriques primaires (711-714, 811-814), et chacun desdits un ou plusieurs transducteurs divisés piézoélectriques primaires couvre un premier secteur correspondant de l'anneau, lesdits un ou plusieurs transducteurs divisés piézoélectriques primaires générant le mode d'oscillation primaire dans le gyroscope à anneau, et un ou plusieurs transducteurs divisés piézoélectriques secondaires (731-734, 831-834), et chacun desdits un ou plusieurs transducteurs divisés piézoélectriques secondaires couvre un deuxième secteur correspondant de l'anneau, lesdits un ou plusieurs transducteurs divisés piézoélectriques secondaires mesurant l'amplitude oscillatoire de l'oscillation secondaire dans le gyroscope à anneau,
et chaque premier secteur croise un axe de symétrie transversale de l'anneau et est symétrique par rapport audit axe de symétrie, et chaque deuxième secteur croise un axe de symétrie diagonale de l'anneau et est symétrique par rapport audit axe de symétrie, et le gyroscope comprend en outre un ou plusieurs transducteurs divisés piézoélectriques tertiaires (751-758, 855-856), et chacun desdits un ou plusieurs transducteurs divisés piézoélectriques tertiaires couvre un troisième secteur correspondant de l'anneau, et aucun troisième secteur ne chevauche un premier secteur ou un deuxième secteur,
dans lequel lesdits un ou plusieurs transducteurs divisés piézoélectriques primaires comprennent une première paire de transducteurs divisés piézoélectriques primaires sur deux premiers secteurs qui croisent le premier axe de symétrie transversale sur des côtés opposés de l'anneau et une deuxième paire de transducteurs divisés piézoélectriques primaires sur deux premiers secteurs qui croisent le deuxième axe de symétrie transversale sur des côtés opposés de l'anneau,
et lesdits un ou plusieurs transducteurs divisés piézoélectriques secondaires comprennent une première paire de transducteurs divisés piézoélectriques secondaires sur deux deuxièmes secteurs qui croisent le premier axe de symétrie diagonale sur des côtés opposés de l'anneau et une deuxième paire de transducteurs divisés piézoélectriques secondaires sur deux deuxièmes secteurs qui croisent le deuxième axe de symétrie diagonale sur des côtés opposés de l'anneau.

2. Gyroscope à anneau selon la revendication 1, **caractérisé en ce que** la première paire de transducteurs divisés piézoélectriques primaires présente une symétrie de polarité par rapport au centre de l'anneau qui est opposée à la symétrie de polarité de la deuxième paire de transducteurs divisés piézoélectriques primaires par rapport au centre de l'anneau.

3. Gyroscope à anneau selon l'une des revendications 1 à 2, **caractérisé en ce que** la première paire de transducteurs divisés piézoélectriques secondaires présente une symétrie de polarité par rapport au centre de l'anneau qui est opposée à la symétrie de polarité de la deuxième paire de transducteurs divisés piézoélectriques secondaires par rapport au centre de l'anneau.

4. Gyroscope à anneau selon l'une des revendications 1 à 3, **caractérisé en ce que** la largeur de chaque premier secteur est inférieure à 45° et la largeur de chaque deuxième secteur est supérieure à 45°.

5. Gyroscope à anneau selon l'une des revendications 1 à 3, **caractérisé en ce que** la largeur de chaque premier secteur est supérieure à 45° et la largeur de chaque deuxième secteur est inférieure à 45°.

6. Gyroscope à anneau selon l'une des revendications 1 à 3, **caractérisé en ce que** la largeur de chaque premier secteur est inférieure à 45° et la largeur de chaque deuxième secteur est inférieure à 45°.

7. Procédé pour l'utilisation d'un gyroscope à anneau qui comprend :
- un anneau essentiellement circulaire et flexible qui définit un plan annulaire et qui est suspendu de manière flexible à un substrat de telle façon que l'anneau puisse subir une oscillation de forme dans le plan annulaire, ledit anneau comprenant des premier et deuxième axes de symétrie transversale dans le plan annulaire qui sont orthogonaux entre eux, et ledit anneau comprenant également des premier et deuxième axes de symétrie diagonale dans le plan annulaire qui sont orthogonaux entre eux, et l'angle entre chaque axe de symétrie transversale et l'axe de symétrie diagonale adjacent étant de 45°,
- un ou plusieurs transducteurs divisés piézoélectriques primaires, chacun desdits un ou plusieurs transducteurs divisés piézoélectriques primaires couvrant un premier secteur correspondant de l'anneau, lesdits un ou plusieurs transducteurs divisés piézoélectriques primaires générant le mode d'oscillation primaire dans le gyroscope à anneau, et un ou plusieurs transducteurs divisés piézoélectriques secondaires, chacun desdits un ou plusieurs transducteurs divisés piézoélectriques secondaires couvrant un deuxième secteur correspondant de l'anneau, lesdits un ou plusieurs transducteurs divisés piézoélectriques secondaires mesurant l'amplitude oscillatoire de l'oscillation secondaire dans le gyroscope à anneau, et chaque premier secteur croisant un axe de symétrie transversale de l'anneau et étant symétrique par rapport audit axe de symétrie, et chaque deuxième secteur croisant un axe de symétrie diagonale de l'anneau et étant symétrique par rapport audit axe de symétrie diagonale de l'anneau,
dans lequel lesdits un ou plusieurs transducteurs divisés piézoélectriques primaires comprennent une première paire de transducteurs divisés piézoélectriques primaires sur deux premiers secteurs qui croisent le premier axe de symétrie transversale sur des côtés opposés de l'anneau et une deuxième paire de transducteurs divisés piézoélectriques primaires sur deux premiers secteurs qui croisent le deuxième axe de symétrie transversale sur des côtés opposés de l'anneau,
et lesdits un ou plusieurs transducteurs divisés piézoélectriques secondaires comprennent une première paire de transducteurs divisés piézoélectriques secondaires sur deux deuxièmes secteurs qui croisent le premier axe de symétrie diagonale sur des côtés opposés de l'anneau et une deuxième paire de transducteurs divisés piézoélectriques secondaires sur deux deuxièmes secteurs qui croisent le deuxième axe de symétrie diagonale sur des côtés opposés de l'anneau, et
le gyroscope à anneau comprend également un ou plusieurs transducteurs divisés piézoélectriques tertiaires, et chacun desdits un ou plusieurs transducteurs divisés piézoélectriques tertiaires couvre un troisième secteur correspondant de l'anneau, et aucun troisième secteur ne chevauche un premier secteur ou un deuxième secteur, et le procédé comprend les étapes consistant à :
- appliquer un signal de tension d'excitation à au moins un transducteur divisé piézoélectrique primaire pour générer le mode d'oscillation primaire dans le gyroscope à anneau,
- lire un signal de tension de détection venant d'au moins un transducteur divisé piézoélectrique secondaire pour mesurer l'amplitude oscillatoire de l'oscillation secondaire dans le gyroscope à anneau.

8. Procédé selon la revendication 7, **caractérisé en ce que** le procédé comprend également l'étape consistant à lire un troisième signal de tension venant d'au moins un transducteur divisé piézoélectrique primaire pour mesurer l'amplitude oscillatoire de l'oscillation primaire dans le gyroscope à anneau.

9. Procédé selon l'une des revendications 7 à 8, **caractérisé en ce que** le procédé comprend également l'étape consistant à appliquer un quatrième signal de tension à au moins un transducteur divisé piézoélectrique secondaire pour annuler activement le couplage de l'oscillation primaire dans l'oscillation secondaire.

10. Procédé selon l'une des revendications 7 à 9, **caractérisé en ce que** le procédé comprend également l'étape consistant à lire un cinquième signal de tension venant d'au moins un transducteur divisé piézoélectrique tertiaire pour mesurer l'amplitude oscillatoire de l'oscillation primaire dans le gyroscope à anneau.

11. Procédé selon l'une des revendications 7 à 10, **caractérisé en ce que** le procédé comprend également l'étape consistant à appliquer un sixième signal de tension à au moins un transducteur divisé piézoélectrique tertiaire pour annuler activement le couplage de l'oscillation primaire dans l'oscillation secondaire.
